# EUROPEAN PATENT APPLICATION

(11) **EP 4 535 415 A1**
(43) Date of publication of application: **09.04.2025**
(21) Application number: 24315323.6
(22) Date of filing: 04.07.2024
(51) Int. Cl.: H01L 23/00

(54) **IMPROVED UNDER-BUMP METALLIZATION STRUCTURES AND ASSOCIATED METHODS OF FORMATION**

(30) Priority: 10.07.2023 US 202318349351
(71) Applicant: STMicroelectronics International N.V., 1228 Plan-les-Ouates, Geneva (CH)
(72) Inventor: Boufnichel, Mohamed, 37380 MONNAIE (FR)
(74) Representative: Cabinet Beaumont

(57) **Abstract**

Methods, systems, and devices for semiconductor manufacturing are described. One such method includes forming a first layer comprising a first material. A top surface of the first layer extends along a first direction and a second direction. In some cases, the method includes forming, on at least the top surface of the first layer, a second layer comprising a second material, and forming a void in the second layer. Forming the void may expose a portion of the top surface of the first layer. In some cases, the method may include forming one or more layers on a top surface of the second layer and on the exposed portion of the top surface of the first layer. The method may also include performing a material removal operation that lifts portions of the one or more layers formed on the top surface of the second layer off of the top surface.

## Description

### FIELD OF THE INVENTION

Example embodiments of the present disclosure generally relate to semiconductor devices and fabrication techniques. More specifically, the present disclosure relates to improved under-bump metallization structures and associated methods of formation.

### BACKGROUND

Some semiconductor devices may include layers of various materials, formed in a stack above a semiconductor substrate. Such semiconductor devices may be formed using a variety of techniques, such as photolithography, etching, deposition, doping, and other techniques. Such techniques may be utilized to form patterns in the various materials and configurations that enable the operation of the semiconductor device. In some cases, a semiconductor device may include various structures for coupling with other devices, such as other semiconductor devices. For example, a semiconductor device may include one or more layers formed in such a way that the semiconductor device may be coupled with another semiconductor device (e.g., via soldering, via flip-chip bonding).

### BRIEF SUMMARY

Various embodiments described herein relate to methods, apparatuses, and systems associated with improved under-bump metallization structures. In one aspect, a method includes forming a first layer including a first material, where a top surface of the first layer extends along a first direction and a second direction, the first direction parallel to a width of the first layer and the second direction parallel to a depth of the first layer, forming, on at least the top surface of the first layer, a second layer including a second material, forming a void in the second layer, where forming the void exposes a portion of the top surface of the first layer, forming one or more layers on a top surface of the second layer and on the exposed portion of the top surface of the first layer, and performing a material removal operation, where the material removal operation lifts portions of the one or more layers formed on the top surface of the second layer off of the top surface.

In some cases, forming the one or more layers includes forming, on the top surface of the second layer and on the exposed portion of the top surface of the first layer, a third layer including a third material, forming, on a top surface of the third layer, a fourth layer including a fourth material, and forming, on a top surface of the fourth layer, a fifth layer including a fifth material. In some cases, performing the material removal operation may include removing the portions of the one or more layers using an adhesive film. The method may also include forming a sixth material on a top layer of the one or more layers, where forming the sixth material avoids forming the sixth material in contact with the second layer. The method may also include forming a sixth layer including the second material, where the first layer is formed on the sixth layer.

The method may also include performing a reflow operation, where performing the reflow operation couples the first layer with a device via at least the one or more layers. The method may also include forming, on a top layer of the one or more layers, a pillar including a seventh material, where a height axis of the pillar extends along a third direction parallel to a height of the first layer, and forming, on a top surface of the pillar, a seventh layer including a fourth material. In some cases, the one or more layers comprise an under-bump metallization. Other technical features may be readily apparent to one skilled in the art from the following figures, descriptions, and claims.

In some cases, the first material may be aluminum, the second material may be silicon nitride, the third material may be titanium, the fourth material may be nickel, and the fifth material may be silver. In some cases, a height dimension of the fourth layer may be greater than or equal to 300 nanometers. In some cases, the sixth material may include a solder material.

In one aspect, an apparatus includes a first layer including a first material, where the first layer has a width parallel to a first direction, a depth parallel to a second direction, and a height parallel to a third direction, a second layer including a second material formed on at least a top surface of the first layer, the top surface of the first layer extending along the first direction and the second direction, a void formed in the second layer, where extents of the void comprise sidewalls of the second layer and a portion of the top surface of the first layer, where the sidewalls of the second layer are parallel to the third direction, and one or more layers formed on the sidewalls of the second layer and on the portion of the top surface of the first layer, the one or more layers for coupling the first layer with a bonding material. In some cases, the one or more layers may include a third layer including a third material, the third layer formed on a top surface of the second layer, a fourth layer may include a fourth material, the fourth layer formed on a top surface of the third layer, and a fifth layer may include a fifth material, the fifth layer formed on a top surface of the fourth layer. In some cases, the bonding material may include solder.

The apparatus may also include a sixth layer including the second material, where the first layer is formed on the sixth layer. The apparatus may also include a pillar including a seventh material, where a height axis of the pillar extends along the third direction, and a seventh layer including a fourth material, the seventh layer formed on a top surface of the pillar. In some cases, the one or more layers may include an under-bump metallization. Other technical features may be readily apparent to one skilled in the art from the following figures, descriptions, and claims.

In some cases, the first material may be aluminum, the second material may be silicon nitride, the third material may be titanium, the fourth material may be nickel, and the fifth material may be silver. In some cases, a height dimension of the fourth layer may be greater than or equal to 300 nanometers. In some cases, the sixth material may include a solder material.

In one aspect, a product may be formed by a method including forming a first layer including a first material, where a top surface of the first layer extends along a first direction and a second direction, the first direction parallel to a width of the first layer and the second direction parallel to a depth of the first layer, forming, on at least the top surface of the first layer, a second layer includes a second material, forming a void in the second layer, where forming the void exposes a portion of the top surface of the first layer, forming one or more layers on a top surface of the second layer and on the exposed portion of the top surface of the first layer, and performing a material removal operation, where the material removal operation lifts (e.g., removes) portions of the one or more layers formed on the top surface of the second layer off of the top surface.

In some cases, forming the one or more layers includes forming, on the top surface of the second layer and on the exposed portion of the top surface of the first layer, a third layer including a third material, forming, on a top surface of the third layer, a fourth layer including a fourth material, and forming, on a top surface of the fourth layer, a fifth layer including a fifth material. In some cases, performing the material removal operation may include removing the portions of the one or more layers using an adhesive film. The method for forming the product may also include forming a sixth material on a top layer of the one or more layers, where forming the sixth material avoids forming the sixth material in contact with the second layer. The method for forming the product may also include forming a sixth layer including the second material, where the first layer is formed on the sixth layer.

The method for forming the product may also include performing a reflow operation, where performing the reflow operation couples the first layer with a device via at least the one or more layers. The method for forming the product may also include forming, on a top layer of the one or more layers, a pillar including a seventh material, where a height axis of the pillar extends along a third direction parallel to a height of the first layer, and forming, on a top surface of the pillar, a seventh layer including a fourth material. In some cases, the one or more layers comprise an under-bump metallization. Other technical features may be readily apparent to one skilled in the art from the following figures, descriptions, and claims.

In some cases, the first material may be aluminum, the second material may be silicon nitride, the third material may be titanium, the fourth material may be nickel, and the fifth material may be silver. In some cases, a height dimension of the fourth layer may be greater than or equal to 300 nanometers. In some cases, the sixth material may include a solder material.

In one aspect, a non-transitory computer-readable storage medium may include instructions that when executed by a computer, cause the computer to form a first layer including a first material, where a top surface of the first layer extends along a first direction and a second direction, the first direction parallel to a width of the first layer and the second direction parallel to a depth of the first layer, form, on at least the top surface of the first layer, a second layer including a second material, form a void in the second layer, where forming the void exposes a portion of the top surface of the first layer, form one or more layers on a top surface of the second layer and on the exposed portion of the top surface of the first layer, and perform a material removal operation, where the material removal operation lifts portions of the one or more layers formed on the top surface of the second layer off of the top surface.

In some cases, forming the one or more layers includes forming, on the top surface of the second layer and on the exposed portion of the top surface of the first layer, a third layer including a third material, forming, on a top surface of the third layer, a fourth layer including a fourth material, and forming, on a top surface of the fourth layer, a fifth layer including a fifth material. In some cases, performing the material removal operation may include removing the portions of the one or more layers using an adhesive film. The instructions executed by the computer may also cause the computer to form a sixth material on a top layer of the one or more layers, where forming the sixth material avoids forming the sixth material in contact with the second layer. The instructions executed by the computer may also cause the computer to form a sixth layer including the second material, where the first layer is formed on the sixth layer.

The instructions executed by the computer may also cause the computer to perform a reflow operation, where performing the reflow operation couples the first layer with a device via at least the one or more layers. The instructions executed by the computer may also cause the computer to form, on a top layer of the one or more layers, a pillar including a seventh material, where a height axis of the pillar extends along a third direction parallel to a height of the first layer, and form, on a top surface of the pillar, a seventh layer including a fourth material. In some cases, the one or more layers comprise an under-bump metallization. Other technical features may be readily apparent to one skilled in the art from the following figures, descriptions, and claims.

In one aspect, a computing apparatus includes a processor. The computing apparatus also includes a memory storing instructions that, when executed by the processor, configure the apparatus to form a first layer including a first material, where a top surface of the first layer extends along a first direction and a second direction, the first direction parallel to a width of the first layer and the second direction parallel to a depth of the first layer, form, on at least the top surface of the first layer, a second layer including a second material, form a void in the second layer, where forming the void exposes a portion of the top surface of the first layer, form one or more layers on a top surface of the second layer and on the exposed portion of the top surface of the first layer, and perform a material removal operation, where the material removal operation lifts portions of the one or more layers formed on the top surface of the second layer off of the top surface.

In some cases, forming the one or more layers includes forming, on the top surface of the second layer and on the exposed portion of the top surface of the first layer, a third layer including a third material, forming, on a top surface of the third layer, a fourth layer including a fourth material, and forming, on a top surface of the fourth layer, a fifth layer including a fifth material.

In some cases, performing the material removal operation includes removing the portions of the one or more layers using an adhesive film. The instructions may also configure the apparatus to form a sixth material on a top layer of the one or more layers, where forming the sixth material avoids forming the sixth material in contact with the second layer. The instructions may also configure the apparatus to form a sixth layer including the second material, where the first layer is formed on the sixth layer.

In some cases, the instructions further configure the apparatus to perform a reflow operation, where performing the reflow operation couples the first layer with a device via at least the one or more layers. The instructions may further configure the apparatus to form, on a top layer of the one or more layers, a pillar including a seventh material, where a height axis of the pillar extends along a third direction parallel to a height of the first layer, and form, on a top surface of the pillar, a seventh layer includes a fourth material. In some cases, the one or more layers may be an example of an under-bump metallization. Other technical features may be readily apparent to one skilled in the art from the following figures, descriptions, and claims.

In some cases, the first material may be aluminum, the second material may be silicon nitride, the third material may be titanium, the fourth material may be nickel, and the fifth material may be silver. In some cases, a height dimension of the fourth layer may be greater than or equal to 300 nanometers. In some cases, the sixth material may include a solder material.

An embodiment provides a method comprising:
forming a first layer comprising a first material, wherein a top surface of the first layer extends along a first direction and a second direction, the first direction parallel to a width of the first layer and the second direction parallel to a depth of the first layer;
forming, on at least the top surface of the first layer, a second layer comprising a second material;
forming a void in the second layer, wherein forming the void exposes a portion of the top surface of the first layer;
forming one or more layers on a top surface of the second layer and on the exposed portion of the top surface of the first layer; and
performing a material removal operation, wherein the material removal operation lifts portions of the one or more layers formed on the top surface of the second layer off of the top surface.

According to an embodiment, wherein forming the one or more layers comprises:
forming, on the top surface of the second layer and on the exposed portion of the top surface of the first layer, a third layer comprising a third material;
forming, on a top surface of the third layer, a fourth layer comprising a fourth material; and
forming, on a top surface of the fourth layer, a fifth layer comprising a fifth material.

According to an embodiment of the method, the first material comprises aluminum, the second material comprises silicon nitride, the third material comprises titanium, the fourth material comprises nickel, and the fifth material comprises silver.

According to an embodiment of the method, a height dimension of the fourth layer is greater than or equal to 300 nanometers.

According to an embodiment, performing the material removal operation comprises:
removing the portions of the one or more layers using an adhesive film.

According to an embodiment, the method further comprises:
forming a sixth material on a top layer of the one or more layers, wherein forming the sixth material avoids forming the sixth material in contact with the second layer.

According to an embodiment, the sixth material comprises a solder material.

According to an embodiment, the method further comprises:
forming a sixth layer comprising the second material, wherein the first layer is formed on the sixth layer.

According to an embodiment, the method further comprises:
performing a reflow operation, wherein performing the reflow operation couples the first layer with a device via at least the one or more layers.

According to an embodiment, the method further comprises:
forming, on a top layer of the one or more layers, a pillar comprising a seventh material, wherein a height axis of the pillar extends along a third direction parallel to a height of the first layer; and
forming, on a top surface of the pillar, a seventh layer comprising a fourth material.

According to an embodiment of the method, the one or more layers comprise an under-bump metallization.

An embodiment provides an apparatus comprising:
a first layer comprising a first material, wherein the first layer has a width parallel to a first direction, a depth parallel to a second direction, and a height parallel to a third direction;
a second layer comprising a second material formed on at least a top surface of the first layer, the top surface of the first layer extending along the first direction and the second direction;
a void formed in the second layer, wherein extents of the void comprise sidewalls of the second layer and a portion of the top surface of the first layer, wherein the sidewalls of the second layer are parallel to the third direction; and
one or more layers formed on the sidewalls of the second layer and on the portion of the top surface of the first layer, the one or more layers for coupling the first layer with a bonding material.

According to an embodiment, the one or more layers comprise:
a third layer comprising a third material, the third layer formed on a top surface of the second layer;
a fourth layer comprising a fourth material, the fourth layer formed on a top surface of the third layer; and
a fifth layer comprising a fifth material, the fifth layer formed on a top surface of the fourth layer.

According to an embodiment of the apparatus, the first material comprises aluminum, the second material comprises silicon nitride, the third material comprises titanium, the fourth material comprises nickel, and the fifth material comprises silver.

According to an embodiment of the apparatus, a height dimension of the fourth layer is greater than or equal to 300 nanometers.

According to an embodiment, the bonding material comprises solder.

According to an embodiment, the apparatus further comprises:
a sixth layer comprising the second material, wherein the first layer is formed on the sixth layer.

According to an embodiment, the apparatus further comprises:
a pillar comprising a seventh material, wherein a height axis of the pillar extends along the third direction; and
a seventh layer comprising a fourth material, the seventh layer formed on a top surface of the pillar.

According to an embodiment of the apparatus, the one or more layers comprise an under-bump metallization.

An embodiment provides a product formed by the disclosed method.

The foregoing illustrative summary, as well as other exemplary objectives and/or advantages of the disclosure, and the manner in which the same are accomplished, are further explained in the following detailed description and its accompanying drawings.

### BRIEF DESCRIPTION OF THE DRAWINGS

The description of the illustrative embodiments may be read in conjunction with the accompanying figures. It will be appreciated that, for simplicity and clarity of illustration, elements illustrated in the figures have not necessarily been drawn to scale, unless described otherwise. For example, the dimensions of some of the elements may be exaggerated relative to other elements, unless described otherwise. Embodiments incorporating teachings of the present disclosure are shown and described with respect to the figures presented herein, in which:
FIG. 1 illustrates an example of a material arrangement that supports improved under-bump metallization structures and associated methods of formation;
FIG. 2 illustrates examples of regions that support improved under-bump metallization structures and associated methods of formation;
FIG. 3 illustrates an example of a process flow that supports improved under-bump metallization structures and associated methods of formation;
FIGs. 4A and 4B illustrate examples of material arrangements that support improved under-bump metallization structures and associated methods of formation;
FIGs. 5A and 5B illustrate examples of material arrangements that support improved under-bump metallization structures and associated methods of formation;
FIG. 6 illustrates an example of a flowchart that supports improved under-bump metallization structures and associated methods of formation; and
FIG. 7 illustrates an example of a flowchart that supports improved under-bump metallization structures and associated methods of formation.

### DETAILED DESCRIPTION OF THE INVENTION

Some embodiments of the present disclosure will now be described more fully hereinafter with reference to the accompanying drawings, in which some, but not all embodiments of the disclosure are shown. Indeed, these disclosures may be embodied in many different forms and should not be construed as limited to the embodiments set forth herein; rather, these embodiments are provided so that this disclosure will satisfy applicable legal requirements. Like numbers refer to like elements throughout.

As used herein, terms such as "front," "rear," "top," etc. are used for explanatory purposes in the examples provided below to describe the relative position of certain components or portions of components. Furthermore, as would be evident to one of ordinary skill in the art in light of the present disclosure, the terms "substantially" and "approximately" indicate that the referenced element or associated description is accurate to within applicable engineering tolerances.

As used herein, the term "comprising" means including but not limited to and should be interpreted in the manner it is typically used in the patent context. Use of broader terms such as comprises, includes, and having should be understood to provide support for narrower terms such as consisting of, consisting essentially of, and comprised substantially of.

The phrases "in one embodiment," "according to one embodiment," and the like generally mean that the particular feature, structure, or characteristic following the phrase may be included in at least one embodiment of the present disclosure and may be included in more than one embodiment of the present disclosure (importantly, such phrases do not necessarily refer to the same embodiment).

The word "example" or "exemplary" is used herein to mean "serving as an example, instance, or illustration." Any implementation described herein as "exemplary" is not necessarily to be construed as preferred or advantageous over other implementations.

If the specification states a component or feature "may," "can," "could," "should," "would," "preferably," "possibly," "typically," "optionally," "for example," "often," or "might" (or other such language) be included or have a characteristic, that a specific component or feature is not required to be included or to have the characteristic. Such a component or feature may be optionally included in some embodiments, or it may be excluded.

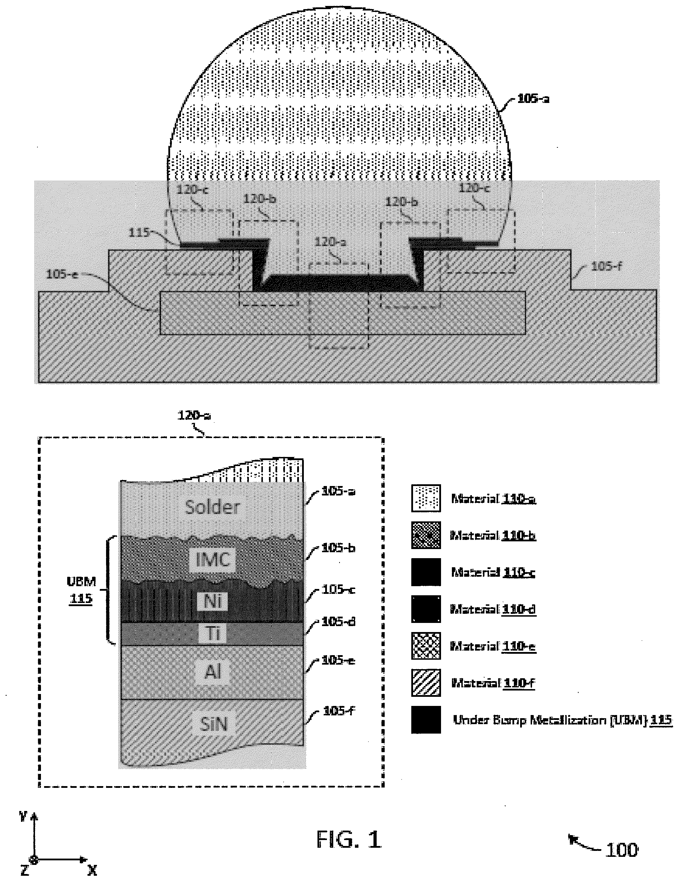

**FIG. 1** illustrates an example of a material arrangement 100 that supports improved under-bump metallization structures and associated methods of formation. In some cases, the material arrangement 100 may be an example of a portion of semiconductor device or any other electronic device. The material arrangement 100 may be a device or a portion of a device employed in a variety of applications such as automotive applications (e.g., for motor control, for a charging module). The material arrangement 100 may illustrate a section view of a semiconductor device where some portions of the semiconductor device may be truncated or not shown. The material arrangement 100 may include one or more layers 105, which may each correspond to one or more materials 110. Although some examples of specific materials 110 or combinations of materials 110 (e.g., compounds, mixtures, composites) are described herein, the material arrangement 100 may include any combination of materials 110.

As described herein, the material arrangement 100 may be an example of a power device or a portion of a power device. For example, the material arrangement 100 may be an example of a transistor (e.g., a power transistor) or a diode (e.g., a power diode, a thin diode). Such power devices may be capable of handling relatively high currents and relatively high voltages when compared to other devices. In some cases, the material arrangement 100 may be an example of a power device (e.g., a transistor, a diode) included in a charging module for an electric vehicle. Additionally, or alternatively, the material arrangement 100 may be an example of a power device (e.g., a transistor, a diode) included in a motor control module for an electric vehicle. In some cases, the material arrangement 100 may be an example of a bipolar junction transistor (BJT), a field effect transistor (FET), a metal-oxide-semiconductor field-effect transistor (MOSFET), an insulated gate bipolar transistor (IGBT), a thyristor, or a silicon-controlled rectifier (SCR).

In one illustrative example the material arrangement 100 may include six layers 105, although any quantity of layers 105 may be used. The material arrangement 100 may include a layer 105-a (e.g., a solder layer), a layer 105-b (e.g., an intermetallic compound (IMC) layer, a layer including at least silver), a layer 105-c (e.g., a nickel layer), a layer 105-d (e.g., a titanium layer), a layer 105-e (e.g., an aluminum layer), and a layer 105-f (e.g., a yttrium-silicon-nitride layer). Each layer 105 may be formed in contact with one or more other layers 105. In some cases, the layer 105-f may be an example of a passivation layer, which other layers 105 may be formed on top of or in contact with. For example, the layer 105-e may be formed on top of or partially within the layer 105-f. In some cases, one or more of the layers 105 may be formed as part of a metallization operation (e.g., final metallization may be performed using TiNiAg).

The layer 105-a may be formed using a material 110-a. The material 110-a may be an example of a conductive material, such as a solder (e.g., a solder alloy). In some cases, the material 110-a may be a tin-lead alloy, a tin-silver alloy, a tin-silver-copper alloy, a tin-copper alloy, or any other alloy. The layer 105-b may be formed using a material 110-b. In some cases, the material 110-b may be an example of a gold-aluminum alloy, a gold-germanium alloy, a nickel-germanium alloy, a palladium-silicon alloy, or any other alloy. The layer 105-c may be formed using the material 110-c. The material 110-c may be an example of nickel or any other conductive material. The layer 105-d may be formed using the material 110-d. The material 110-d may be an example of titanium or any other conductive material. The layer 105-e may be formed using the material 110-e. The material 110-e may be an example of aluminum, aluminum-copper, or any other conductive material. The layer 105-f may be formed using the material 110-f. The material 110-f may be an example of silicon-nitride, yttrium-silicon-nitride, silicon-dioxide, polyimide, or any other passivation material.

One or more of the layers 105 may be included in an under-bump metallization (UBM) 115, which may in some cases be referred to as a UBM layer. For example, the UBM 115 may include the layer 105-b, the layer 105-c, and the layer 105-d. In some cases, the UBM 115 may electrically couple the layer 105-a with the layer 105-e. As described herein, forming the UBM 115 may include one or more operations. For example, one or more deposition operations and one or more etching operations (e.g., one or more wet etching operations) may be performed to form the UBM 115. The UBM 115 may be formed on a surface of the layer 105-e (e.g., a top surface) and on one or more surfaces of the layer 105-f. For example, the UBM 115 may be deposited on both horizontal and vertical surfaces of the layer 105-f, as well as on a horizontal surface of the layer 105-e. As described herein, vertical surfaces may refer to surfaces that occupy a yz-plane, an xy-plane, or any other plane that is perpendicular to the xz-plane. Horizontal surfaces may refer to surfaces that occupy the xz-plane. Vertical and horizontal surfaces as described herein may also be curved or irregular. It should also be understood that the material arrangement 100 may illustrate a cross section of a semiconductor device. Accordingly, the material arrangement 100 may include three-dimensional features, such as cylindrical, spherical, rectangular, or other irregular three-dimensional features. As one illustrative example, a void (e.g., a cylindrical void, a rectangular void) may be formed in the layer 105-f, and the UBM 115 may be formed on the vertical surfaces of the layer 105-f created by the formation of the void.

In some cases, the material arrangement 100 may be formed using one or more operations, such as lithography, etching, deposition, doping, metallization, soldering, or any other type of operation. In some cases, the layer 105-e may be deposited on the layer 105-f, the layer 105-d may be deposited on the layer 105-e, and the layer 105-c may be deposited on the layer 105-d. Although not shown, an additional layer 105 (e.g., a silver layer) may be deposited on the layer 105-c and melted during a soldering operation. That is, the additional layer 105 may be an example of one or more constituents of the layer 105-b. As described herein, the material arrangement 100 may illustrate a stack of materials including one or more layers 105 that have undergone a soldering operation or any other type of operation that results in the formation of the layer 105-b (e.g., an intermetallic compound). The layer 105-b may be an example of a compound or a mixture of one or more materials. For example, the layer 105-b may include solder, silver, nickel, or any other combination of materials.

In some cases, the material arrangement 100 may include one or more layers 105 for coupling the layer 105-e (e.g., a redistribution layer) with circuitry of one or more other devices, such as another semiconductor device (not shown). For example, the layer 105-d, the layer 105-c, and at least a portion of the layer 105-b may an example of a UBM 115, which may refer to a conductive portion of a semiconductor device located below a solder bump (e.g., the layer 105-a). In some cases, the material arrangement 100 may be one example of a plurality of material arrangements 100 of a semiconductor device.

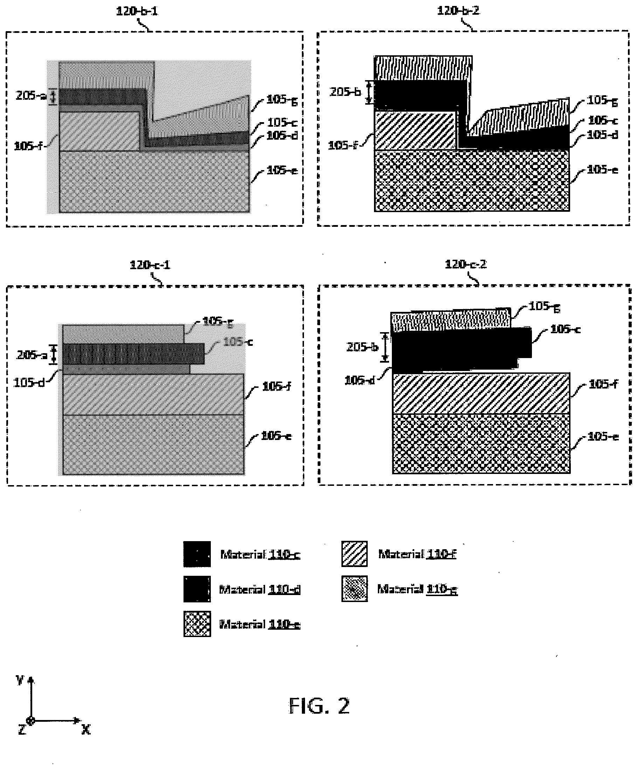

The material arrangement 100 may include one or more regions 120 (e.g., a region 120-a, regions 120-b, regions 120-c), some of which may be described in further detail with reference to FIG. 2. The region 120-a may illustrate a central region of the material arrangement 100 (e.g., of a semiconductor device). The region 120-a may include portions of the layer 105-f, the layer 105-e, the layer 105-d, the layer 105-c, the layer 105-b, and the layer 105-a. The regions 120-b may illustrate corner regions of the material arrangement 100. For example, the regions 120-b may include portions of the UBM 115 located in corners formed by the layer 105-e and the layer 105-f. The regions 120-b may show relatively thin portions of the UBM 115 when compared to other portions of the UBM 115. For example, a cavity (e.g., a crack, a fracture) may be formed in one or more layers 105 of the UBM 115 as a result of challenges associated with forming the UBM 115 in corners. The regions 120-c may be examples of peripheral or edge regions of the material arrangement 100. The regions 120-c may include one or more edges or extents of layers 105 included in the UBM 115.

Some techniques for forming the material arrangement 100 may be associated with various challenges. For example, the UBM 115 may be formed using a physical vapor deposition (PVD) process, which may present some challenges associated with uniformly depositing material where specific geometries are present, such as corners. With reference to the material arrangement 100, the layer 105-e and the layer 105-f may form corners. As a result, various layers 105 of the UBM 115 may not be formed uniformly (e.g., a void or a crack may be formed through one or more layers 105 of the UBM 115, the UBM 115 may be thinned). Accordingly, corner regions of the UBM 115 may be subject to current crowding or may otherwise be subject to a lack of efficient cooling, which may cause failure.

Some other reliability challenges may be associated with forming the UBM 115 in the regions 120-c (e.g., edge regions of the material arrangement 100). For example, some implementations of the PVD process or associated etching processes may result in the formation of overhanging layers 105 (e.g., the layer 105-c may extend beyond the layer 105-d with respect to the x-direction), which may result in mechanical stresses (e.g., when a solder bump is formed on a layer 105 that is overhung). In such cases, mechanical stresses may be exacerbated by increased thicknesses (e.g., along the y-direction) of layers 105, such as the layer 105-c. Additionally, or alternatively, bonding or adhesion between a metallic material and polymeric layers (e.g., the layer 105-d and the layer 105-f) may be relatively weak when compared to adhesion between similar materials (e.g., between two metals), which may result in delamination. Delamination may also be caused by differences in respective coefficients of thermal expansion between layers 105 or by residues (e.g., carbon residues) on a surface of the layer 105-f (e.g., if a photoresist is not properly stripped).

The present disclosure provides methods for efficiently removing portions of a UBM 115 that are associated with or otherwise give rise to various reliability challenges as described above. For example, portions of the UBM 115 that are formed on the layer 105-f may be lifted off using an adhesive tape. In such cases, the UBM 115 may be fractured (e.g., split) at or near cracks formed in the UBM 115 or thin regions of the UBM 115 (e.g., at or near corners formed by the layer 105-f and the layer 105-e). Such removal of UBM 115 portions may be enabled or assisted by various structural instabilities associated with the UBM 115. For example, cracks (e.g., voids) that form in the UBM 115 in sharp corners may result in regions of relative weakness that readily fracture during the lift-off process. Additionally, or alternatively, relatively weak bonding between the layer 105-f and the layer 105-d (e.g., a bottom layer of the UBM 115) may result in delamination that enables lift-off. In some cases, all portions of the UBM 115 in contact with the layer 105-f may be removed. In some other cases, however, some portions of the UBM 115 formed on vertical surfaces of the layer 105-f (e.g., in regions 120-b) may not be removed. For example, the UBM 115 may fracture in a region located above the corner with respect to the y-direction.

In some cases, one or more processing steps that would otherwise increase adhesion between the layer 105-f and the layer 105-d (e.g., a bottom layer of the UBM 115) may not be performed, which may improve processing speed and reduce processing costs. For example, one or more processing steps to remove carbon residue from a surface of the layer 105-f prior to formation of the layer 105-d may be skipped, thereby reducing adhesion of layer 105-d to the layer 105-f and enabling more efficient removal of the UBM 115 portions formed on surfaces of the layer 105-f. Additionally, the techniques described herein may enable a size of the layer 105-a (e.g., a diameter of the solder bump) to be decreased, which may reduce the consumption of the material 110-a and may improve space utilization.

**FIG. 2** illustrates examples of regions 120 that support improved under-bump metallization structures and associated methods of formation. The regions 120 (e.g., regions 120-b, regions 120-c) may be examples of respective regions 120, as described with reference to FIG. 1. For example, the regions 120 may illustrate portions of the material arrangement 100, which may be an example of a semiconductor device or a portion of a semiconductor device. The regions 120 may also illustrate different configurations for a thickness 205 (e.g., a height) of the layer 105-c (e.g., the nickel layer). For example, as shown in the region 120-b-1, the layer 105-c may have a thickness 205-a, and as shown in the region 120-b-2, the layer 105-c may have a thickness 205-b, which may be greater than the thickness 205-a. Similarly, as shown in the region 120-c-1, the layer 105-c may have the thickness 205-a, and as shown in the region 120-c-2, the layer 105-c may have the thickness 205-b. In accordance with examples as described herein, and as shown in FIG. 2, various challenges may be exacerbated by increasing the thickness 205 of the layer 105-c.

Each region 120 may illustrate one or more layers 105 of a material arrangement 100. For example, each region 120 may include a layer 105-g (e.g., a silver layer), a layer 105-c (e.g., a nickel layer), a layer 105-d (e.g., a titanium layer), a layer 105-e (e.g., an aluminum layer), and a layer 105-f (e.g., a silicon-nitride layer). Each layer 105 may be formed in contact with one or more other layers 105. In some cases, the layer 105-f may be an example of a passivation layer. The layer 105-c may be formed using the material 110-c. The material 110-c may be an example of nickel or any other conductive material. The layer 105-d may be formed using the material 110-d. The material 110-d may be an example of titanium or any other conductive material. The layer 105-e may be formed using the material 110-e. The material 110-e may be an example of aluminum, aluminum-copper, or any other conductive material. The layer 105-f may be formed using the material 110-f. The material 110-f may be an example of silicon-nitride, yttrium-silicon-nitride, silicon-dioxide, polyimide, or any other passivation material. The layer 105-g may be formed using the material 110-g. The material 110-g may be an example of silver or any other conductive material.

One or more of the layers 105 may be included in a UBM 115. For example, the UBM 115 may include the layer 105-g, the layer 105-c, and the layer 105-d. As described herein, forming the UBM 115 may include one or more operations. For example, one or more etching operations (e.g., one or more wet etching operations) may be performed to form the UBM 115. The UBM 115 may be formed on a surface of the layer 105-e (e.g., a top surface) and on one or more surfaces of the layer 105-f. For example, the UBM 115 may be deposited on both horizontal and vertical surfaces of the layer 105-f, as well as on a horizontal surface of the layer 105-e.

Some customers may demand increased thickness 205 of the layer 105-c (e.g., up to 2.6 microns (µm)). In some cases, however, increasing a thickness 205 of the layer 105-c may increase various stresses and decrease an extent to which a passivation material (e.g., the layer 105-f) is able to cover the layer 105-c. In some cases, thicknesses 205 for the layer 105-c may range between 300 nanometers (nm) and 2.6 µm. A typical thickness for the layer 105-d may be 200 nm and a typical thickness for the layer 105-g may be 800 nm. In some cases, layers 105 of the UBM 115 may be formed using a spray wet etching operation, which may enable formation of one or more undercuts, as shown in the regions 120-c. For example, one or more spray wet etching operations may be used to remove material from the layer 105-d, the layer 105-c, the layer 105-g, or any combination thereof. In some cases, material removal from layers 105 may form undercut regions. For example, an extent of the layer 105-c in the x-direction may be greater than an extent of the layer 105-d in the x-direction. In some cases, the formation of undercuts or overhangs may cause or exacerbate mechanical stresses between layers 105. Additionally, or alternatively, increased thickness of the layer 105-c may cause or exacerbate mechanical stresses between layers 105. As shown in the region 120-c-2, delamination may occur between the layer 105-d and the layer 105-f. Such delamination may occur if the thickness 205-b satisfies a threshold (e.g., is greater than or equal to a threshold).

Layers 105 of the material arrangement 100 may be formed with varying degrees of conformality. For example, the layer 105-d may be relatively conformal when compared to the layer 105-c and the layer 105-g. Accordingly, the layer 105-d may readily conform to the geometry of the layer 105-f and the layer 105-e. The layers 105-c and the layers 105-g, however, may not conform to the geometry of the layer 105-d. That is, thinning (e.g., stack thinning) may occur in the layer 105-c and the layer 105-g (e.g., at corner regions). Such thinning may cause the layer 105-g and the layer 105-c to have reduced thicknesses in corner regions when compared to portions of the layers 105 formed away from corner regions. In some cases, the thinned regions of the layer 105-g and the layer 105-c may be referred to as voids or cracks. In some cases, thinning of the layer 105-g and the layer 105-c may have negative electrical impacts. For example, thinned regions may create harmonics or present other challenges associated with high frequency electrical signals. In some cases, as described herein, increasing a thickness 205 of the layer 105-c may increase an extent to which the layer 105-c and the layer 105-g are thinned (e.g., in corner regions). Accordingly, the region 120-b-2 illustrates a greater degree of thinning of the layer 105-g and the layer 105-c when compared to the region 120-b-1.

The present disclosure provides methods for UBM 115 formation that enable a thickness 205 of the layer 105-c to be increased without adverse effects (e.g., without delamination). For example, the techniques described herein may include removing portions of the UBM 115 that may otherwise delaminate. For such material removal operations, thinned regions of the UBM 115 may increase ease of removal. For example, regions of the UBM 115 formed on the horizontal surface (e.g., extending along the x-direction and the z-direction) of the layer 105-f may be lifted off of the layer 105-f (e.g., using an adhesive), which may cause the UBM 115 to fracture at or near the thinned regions.

In some cases, one or more processing steps that would otherwise increase adhesion between the layer 105-f and the layer 105-d (e.g., a bottom layer of the UBM 115) may not be performed, which may improve processing speed and reduce processing costs. For example, one or more processing steps to remove carbon residue from a surface of the layer 105-f prior to formation of the layer 105-d may be skipped, thereby reducing adhesion of layer 105-d to the layer 105-f and enabling more efficient removal of the UBM 115 portions formed on surfaces of the layer 105-f.

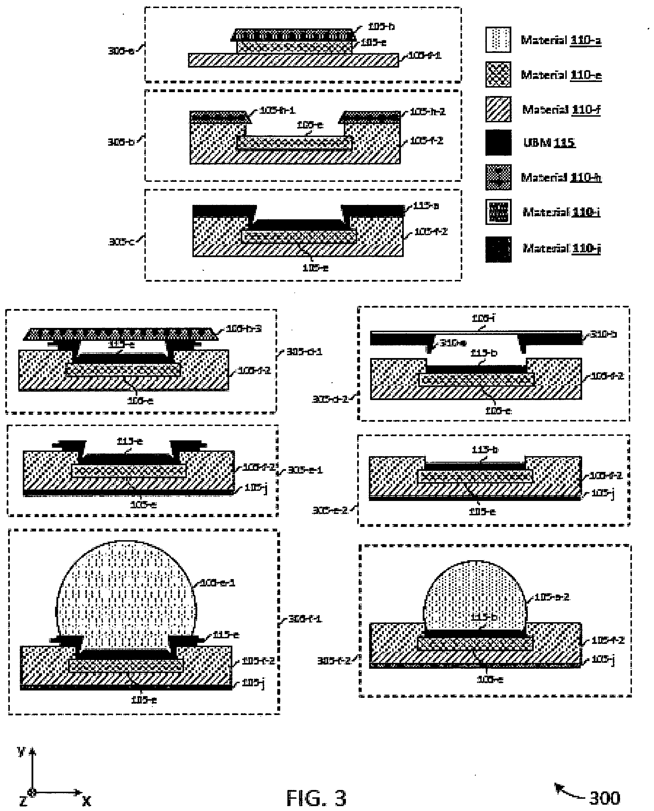

**FIG. 3** illustrates an example of a process flow 300 that supports improved under-bump metallization structures and associated methods of formation. The process flow 300 may illustrate examples of one or more manufacturing operations (e.g., one or more steps 305) used to form a material arrangement 100 (e.g., a semiconductor device), as described with reference to FIG. 1. The process flow 300 may be performed by one or more machines or other manufacturing devices configured to perform the one or more steps 305 described herein. A machine configured to perform the steps 305 described herein may include a controller, a processor, or any other computing device, which may execute code to perform the one or more steps 305. As described herein, the process flow 300 may include one or more steps 305 for forming one or more layers 105 as well as a UBM 115. The one or more layers 105 and the UBM 115 may be examples of respective layers 105 and UBMs 115, as described with reference to FIGs. 1 and 2.

The process flow 300 may include one or more steps 305 (e.g., one or more operations), which may be performed in the order shown or in a different order. In some cases, one or more steps 305 may be omitted from the process flow 300. Additionally, the process flow 300 may illustrate different options for performing the steps 305 described herein. In one example, the process flow 300 may include performing a first set of steps (e.g., the step 305-a, the step 305-b, the step 305-c, the step 305-d-1, the step 305-e-1, and the step 305-f-1). In another example, the process flow 300 may include performing a second set of steps (e.g., the step 305-a, the step 305-b, the step 305-c, the step 305-d-2, the step 305-e-2, and the step 305-f-2). In some cases, one or more steps 305 of the second set may result in one or more processing improvements when compared to one or more respective steps 305 of the first set. For example, performing one or more steps 305 of the second set may result in improved strength of the material arrangement 100, reduced material costs, increased processing speed, and reduced environmental impacts (e.g., by way of reduced use of one or more chemicals). In some cases, improved strength of the material arrangement 100 may enable one or more layers 105 (e.g., a nickel layer) to be formed with increased thickness, which may be desirable for some use cases.

At step 305-a, one or more photolithography operations, one or more etching operations (e.g., aluminum etching operations), and one or more stripping operations (e.g., photoresist stripping operations) may be performed. The step 305-a may be an example of a metal redistribution layer formation operation (e.g., for forming the layer 105-e). The step 305-a may include forming the layer 105-h (e.g., a photoresist). The layer 105-h may be formed using the material 110-h. The material 110-h may be an example of a photoresist material such as a polymer material that is sensitive to ultraviolet (UV) light. In some cases, a pattern may be formed in the layer 105-h by exposing the layer 105-h to UV light that is filtered through a mask. Once the pattern is formed in the layer 105-h, one or more etching operations may be performed to selectively remove portions of the layer 105-e (e.g., portions of the layer 105-e that are not covered or in contact with the layer 105-h. Although the layer 105-h is shown in FIG. 3 as continuous, the layer 105-h may include one or more voids or one or more regions that expose the surface of the layer 105-e. The step 305-a may also include one or more operations to strip the layer 105-h (e.g., after the layer 105-e has been etched).

At step 305-b, one or more deposition operations (e.g., passivation deposition operations), one or more photolithography operations, one or more etching operations (e.g., passivation etching operations), and one or more stripping operations (e.g., one or more photoresist stripping operations) may be performed. The step 305-b may be an example of a passivation layer formation operation (e.g., for forming the layer 105-f-2). In some cases, the step 305-b may include forming one or more portions of the layer 105-f-2. For example, one or more portions of the material 110-f may be formed on surfaces of the layer 105-f-1 and on surfaces of the layer 105-e, resulting in formation of the portions of the layer 105-f-2 as shown. The step 305-b may also include forming the layer 105-h-1 and forming the layer 105-h-2. The layer 105-h-1 and the layer 105-h-2 may be formed using the material 110-h. In some cases, the layer 105-f-2 may be formed using an etching operation to selectively remove portions of the layer 105-f-2 that are not in contact with the layer 105-h-1 or the layer 105-h-2. The step 305-b may also include performing one or more operations to remove the layer 105-h-1 and the layer 105-h-2.

At step 305-c, one or more deposition operations (e.g., UBM 115-a deposition operations) may be performed. In some cases, the one or more deposition operations may include one or more physical vapor depositions (PVD) operations. For example, the UBM 115-a may be formed using the one or more PVD operations. The UBM 115-a may be formed on surfaces of the layer 105-f-2 and the layer 105-e, as shown. The UBM 115-a may be thinned in corner regions (e.g., regions where the layer 105-f-2 and the layer 105-e form sharp corners). In such cases, thinned regions of the UBM 115-a may be relatively weak when compared to other regions of the UBM 115-a.

At step 305-d-1, one or more photolithography operations, one or more etching operations (e.g., wet etching operations), and one or more stripping operations (e.g., photoresist stripping operations) may be performed. For example, step 305-d-1 may include forming the layer 105-h-3. The layer 105-h-3 may be formed using the material 110-h. The layer 105-h-3 may be an example of a photoresist for forming regions of the UBM 115-e. For example, one or more etching operations may be performed to selectively remove edge regions of the UBM 115-a, such that the UBM 115-e is formed. The UBM 115-e may include one or more overhung portions, which may result in reduced strength of the UBM 115-e or a tendency of the UBM 115-e to delaminate from the layer 105-f-2. After performing the one or more etching operations, the layer 105-h-3 may be removed (e.g., using a photoresist stripping operation).

Additionally, the step 305-d-1 may include placing the material arrangement 100 on an adhesive film (e.g., a tape) for a grinding operation, performing the grinding operation, and removing the adhesive film. Specifically, the adhesive film may be placed on one or more surfaces of the UBM 115-e. The adhesive film may be utilized for securing the material arrangement 100 while the grinding operation is performed. The grinding operation may include grinding a bottom surface (e.g., with respect to the y-direction) of the layer 105-f-2 (e.g., to flatten or otherwise prepare the surface for formation of the layer 105-j.

At step 305-e-1, one or more etching operations (e.g., spin etching operations) and one or more deposition operations (e.g., one or more PVD operations) may be performed. In some cases, the one or more deposition operations may include forming the layer 105-j (e.g., on a rough surface of the layer 105-f-2, on the ground surface of the layer 105-f-2). The layer 105-j may be formed using the material 110-j. In some cases, the material 110-j may be a composite or a compound including one or more materials 110. For example, although shown as a singular layer 105, the layer 105-j may include one or more layers formed using one or more materials. In one illustrative example, the layer 105-j may include a titanium layer, a nickel layer, and a silver layer. The titanium layer may be formed on the surface of the layer 105-f-2, the nickel layer may be formed on the surface of the titanium layer, and the silver layer may be formed on the surface of the nickel layer.

At step 305-f-1, one or more dicing operations and one or more bumping operations may be performed. The one or more dicing operations may include slicing or cutting the material arrangement 100 into multiple semiconductor devices. The portion of the material arrangement 100 as shown in the process flow 300 may be an example of portion of a semiconductor device included on a single die. The one or more bumping operations may include forming the layer 105-a-1. For example, a solder bump may be formed on the UBM 115-e. The layer 105-a-1 may be formed using the material 110-a, which may be an example of a solder material.

Such techniques for forming the material arrangement 100 (e.g., using the step 305-d-1, the step 305-e-1, and the step 305-f-1) may be associated with various challenges. For example, the PVD process used to form the UBM 115-e may result in the formation of voids or cracks (e.g., thinned regions of the UBM 115-e) in or near sharp corners. Such thinned regions of the UBM 115 may cause current crowding or may otherwise be subject to a lack of efficient cooling, which may cause failure. Some other reliability challenges may be associated with edge regions of the UBM 115 where overhung layers 105 are present. Such overhung layers may result in mechanical stresses (e.g., when the layer 105-a-1 exerts downward force on the overhung regions of the UBM 115-e). Additionally, or alternatively, bonding or adhesion between metallic and polymeric materials (e.g., the UBM 115-e and the layer 105-f-2) may be relatively weak when compared to adhesion between similar materials (e.g., between two metals), which may result in delamination.

The present disclosure provides methods for efficiently removing portions of a UBM 115-a (e.g., removing the portion 310-a and the portion 310-b) that are associated with or otherwise give rise to various reliability challenges as described above. Such removal of the portion 310-a and the portion 310-b may be enabled or assisted by various structural instabilities associated with the UBM 115-a. For example, thinned regions of the UBM 115-a may be relatively weak and may readily fracture when the material arrangement 100 is removed from an adhesive film as described herein. Additionally, or alternatively, relatively weak bonding between the UBM 115-a and the layer 105-f-2 may result in delamination that enables removal of the portion 310-a and the portion 310-b.

In some cases, one or more processing steps that would otherwise increase adhesion between the layer 105-f-2 and the portions 310 may not be performed, which may improve processing speed and reduce processing costs. For example, one or more processing steps to remove carbon residue from a surface of the layer 105-f-2 prior to formation of the UBM 115-a may be skipped, thereby reducing adhesion of the UBM 115-a to the layer 105-f-2 and enabling more efficient removal of the portions 310 on surfaces of the layer 105-f-2. Additionally, the techniques described herein may enable a size of the layer 105-a-2 (e.g., a diameter of the solder bump) to be decreased, which may reduce the consumption of the material 110-a and may improve space utilization.

In accordance with one or more examples as described herein, the following steps 305 may be performed. At step 305-d-2, the portion 310-a and the portion 310-b (e.g., portions 310 of the UBM 115-a) may be lifted off using the layer 105-i. The layer 105-i may be formed using the material 110-i (e.g., an adhesive material, a tape material). In some cases, the layer 105-i may be an example of an adhesive film. As described herein, removal of the portions 310 may be accomplished without the use of chemical products, which may reduce costs and environmental impact associated with such chemical products. Removing the portions 310 may result in side-on-side contact between the UBM 115-b and the layer 105-f-2. That is, extents of the UBM 115-b with respect to the x-direction may be aligned with and in contact with extents (e.g., inner extents) of the layer 105-f-2 with respect to the x-direction. Additionally, removing the portions 310 from the UBM 115-a may enable one or more operations performed at step 305-d-1 to be skipped. For example, formation of the layer 105-h-3 and associated etching operations of the UBM 115-e may not be performed, which may improve processing speed.

At step 305-e-2, one or more etching operations (e.g., spin etching operations) and one or more deposition operations (e.g., one or more PVD operations) may be performed. In some cases, the one or more deposition operations may include forming the layer 105-j (e.g., on a rough surface of the layer 105-f-2, on the ground surface of the layer 105-f-2). The layer 105-j may be formed using the material 110-j. In some cases, the material 110-j may be a composite or a compound including one or more materials 110. For example, although shown as a singular layer 105, the layer 105-j may include one or more layers formed using one or more materials. In one illustrative example, the layer 105-j may include a titanium layer, a nickel layer, and a silver layer. The titanium layer may be formed on the surface of the layer 105-f-2, the nickel layer may be formed on the surface of the titanium layer, and the silver layer may be formed on the surface of the nickel layer.

At step 305-f-2, one or more dicing operations and one or more bumping operations may be performed. The one or more dicing operations may include slicing or cutting the material arrangement 100 into multiple semiconductor devices. The portion of the material arrangement 100 as shown in the process flow 300 may be an example of portion of a semiconductor device included on a single die. The one or more bumping operations may include forming the layer 105-a-2. For example, a solder bump may be formed on the UBM 115-b. The layer 105-a-2 may be formed using the material 110-a, which may be an example of a solder material. In some cases, the layer 105-a-2 may have a smaller diameter or a smaller size than the layer 105-a-1, which may reduce manufacturing costs and improve space utilization for the material arrangement 100.

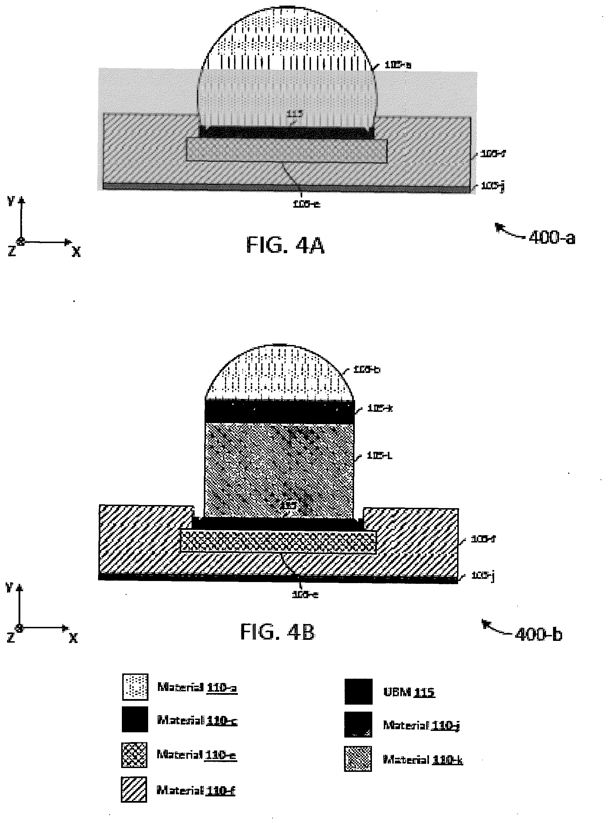

**FIGs. 4A and 4B** illustrate material arrangements 400 that support improved under-bump metallization structures and associated methods of formation. The material arrangements 400 may be examples of the material arrangement 100 as described with reference to FIG. 1. Additionally, the material arrangements 400 may each include one or more layers 105, which may be examples of the one or more layers 105, as described with reference to FIGs. 1-3. The one or more layers 105 may be formed using one or more materials 110, which may be examples of materials 110 described with reference to FIGs. 1-3. The material arrangement 400-b may be an example of a pillar configuration and the material arrangement 400-a may be an example of a bump configuration. As described herein, techniques for formation of material arrangements 400, and more specifically UBMs 115, may be applied for both bump and pillar configurations.

The material arrangements 400 may each include a layer 105-j, a layer 105-f, a layer 105-e, and a UBM 115. The layers 105 and the UBM 115 may be formed using the one or more operations described with reference to the process flow 300 of FIG. 3. In some cases, however, as illustrated by the material arrangement 400-a, a layer 105-a (e.g., a solder bump) may be formed on the UBM 115. The layer 105-a may conform to a width (e.g., along the x-direction) of the UBM 115. That is, a surface of the layer 105-a in contact with the UBM 115 may have a same width as the UBM 115. In some cases, the layer 105-a may be formed to avoid contact with the layer 105-f.

The material arrangement 400-b, however, may include one or more layers 105 between the layer 105-b and the UBM 115. For example, a layer 105-L may be formed in contact with the UBM 115. The layer 105-L may have a cylindrical shape (e.g., with a height axis extending along the y-direction). The layer 105-L may be formed using the material 110-k, which may be an example of a conductive material such as copper. In some cases, a diameter of the layer 105-L may be less than a width of the UBM 115. A layer 105-k may be formed in contact with the layer 105-L. The layer 105-k may also have a cylindrical shape with a height axis extending along the y-direction. The layer 105-k and the layer 105-L may have a same diameter. The layer 105-k may be formed using the material 110-j. The material 110-j may be an example of a conductive material such as nickel. The layer 105-b may be formed in contact with the layer 105-k.

As described herein, the layer 105-a and the layer 105-b may be coupled with the UBM 115 and the layer 105-e. The layer 105-a and the layer 105-b may be melted or partially melted during a reflow operation, during which the material arrangements 400 may be coupled with one or more other devices. Accordingly, the layer 105-a, the layer 105-b, the layer 105-k, the layer 105-L, and the UBM 115 may provide an electrical path for coupling one or more devices or electrical components with the layer 105-e. As shown, the UBM 115 may be formed on the surface of the layer 105-e and may not be formed on horizontal surfaces of the layer 105-f, which may improve durability and reduce manufacturing costs associated with the material arrangements 400.

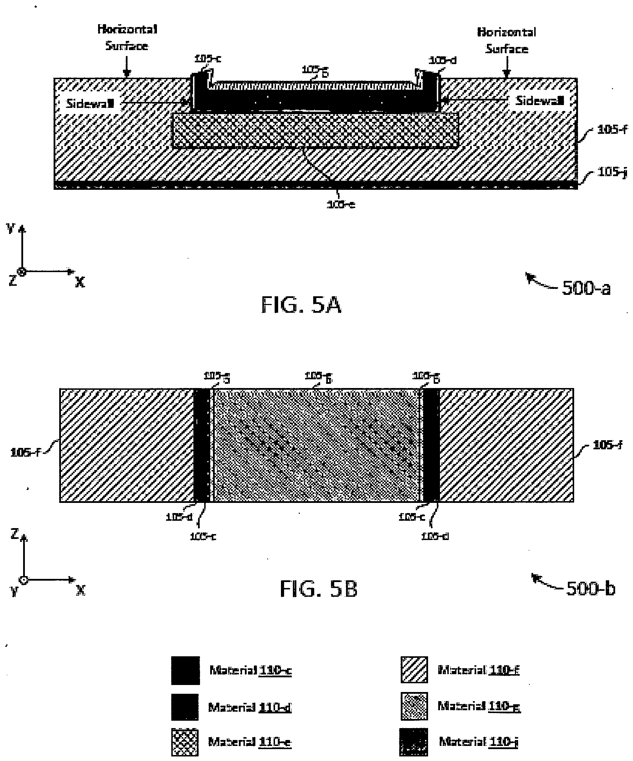

**FIGs. 5A and 5B** illustrate material arrangements 500 that support improved under-bump metallization structures and associated methods of formation. The material arrangements 500 may be examples of the material arrangement 100 and the material arrangements 400, as described with reference to FIGs. 1, 4A, and 4B. The material arrangements 500 may each include one or more layers 105, which may be examples of the one or more layers 105, as described with reference to FIGs. 1-4B. The one or more layers 105 may be formed using one or more materials 110, which may be examples of materials 110 described with reference to FIGs. 1-4B. The material arrangement 500-a may be an example of a side view of a portion of the material arrangement 400-a (e.g., excluding the solder bump). The material arrangement 500-b may be an example of a top view of the material arrangement 500-a.

The material arrangements 500 may illustrate layers 105 of a UBM 115 after portions 310 of the UBM 115 have been removed. In some cases, material removal operations (e.g., to remove the portions 310) may result in the UBM 115 being fractured or cut in different locations. In one illustrative example, as shown in FIGs. 5A and 5B, fracturing of the UBM 115 may result in the layer 105-g, the layer 105-c, and the layer 105-d being visible when the material arrangement 500 is viewed from above. In such cases, portions of layers 105 formed along (e.g., parallel with) sidewalls of the layer 105-f may not be removed. Accordingly, vertical portions (e.g., extending along the y-direction) of the layer 105-c, the layer 105-d, and the layer 105-g may be visible when the material arrangement 500 is viewed from above. As shown, the UBM 115 (e.g., the layer 105-g, the layer 105-c, and the layer 105-d) may be formed on the surface of the layer 105-e and sidewalls of the layer 105-f. The UBM 115 may not be formed on horizontal surfaces of the layer 105-f, which may improve durability and reduce manufacturing costs associated with the material arrangement 500.

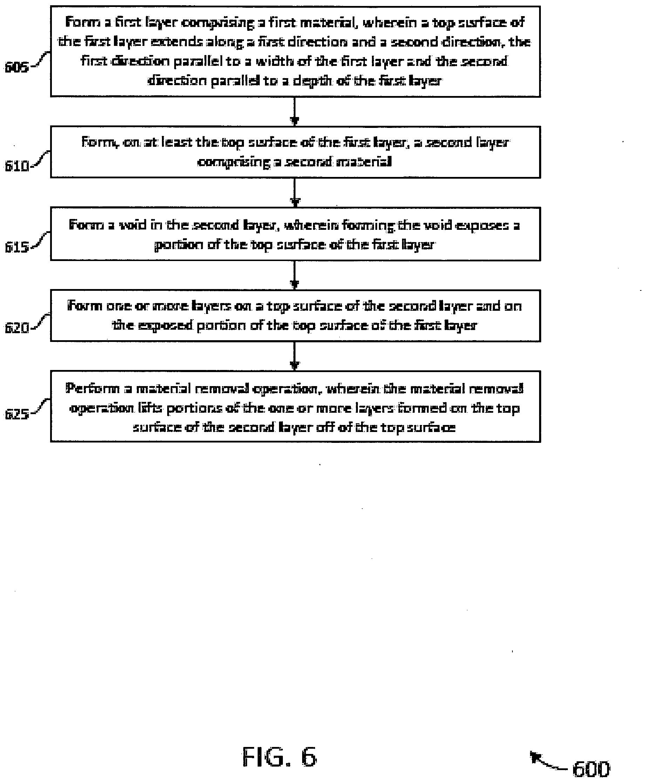

**FIG.** 6 illustrates an example of a flowchart illustrating a method 600 that supports improved under-bump metallization structures and associated methods of formation. The operations of the method 600 may be implemented by a manufacturing system or one or more machines configured for performing the one or more operations as described herein. In some cases, a manufacturing system or machine may execute instructions to control one or more functional elements to perform the described operations. Additionally, or alternatively, a machine or manufacturing system may perform aspects of the described operations using special-purpose hardware.

At 605, the method 600 may include forming a first layer comprising a first material. In some cases, a top surface of the first layer may extend along a first direction and a second direction. The first direction may be parallel to a width of the first layer and the second direction may be parallel to a depth of the first layer. The operations may be performed in accordance with examples as described herein. In some examples, aspects of the operations may be performed using a special-purpose machine or manufacturing system.

At 610, the method 600 may include forming, on at least the top surface of the first layer, a second layer. The second layer may include a second material. The operations may be performed in accordance with examples as described herein. In some examples, aspects of the operations may be performed using a special-purpose machine or manufacturing system.

At 615, the method 600 may include forming a void in the second layer. In some cases, forming the void may expose a portion of the top surface of the first layer. The operations may be performed in accordance with examples as described herein. In some examples, aspects of the operations may be performed using a special-purpose machine or manufacturing system.

At 620, the method 600 may include forming one or more layers on a top surface of the second layer and on the exposed portion of the top surface of the first layer. The operations may be performed in accordance with examples as described herein. In some examples, aspects of the operations may be performed using a special-purpose machine or manufacturing system.

At 625, the method 600 may include performing a material removal operation (e.g., a lift-off operation using an adhesive film). The material removal operation may remove one or more portions of the one or more layers formed on the top surface of the second layer. The operations may be performed in accordance with examples as described, herein. In some examples, aspects of the operations may be performed using a special-purpose machine or manufacturing system.

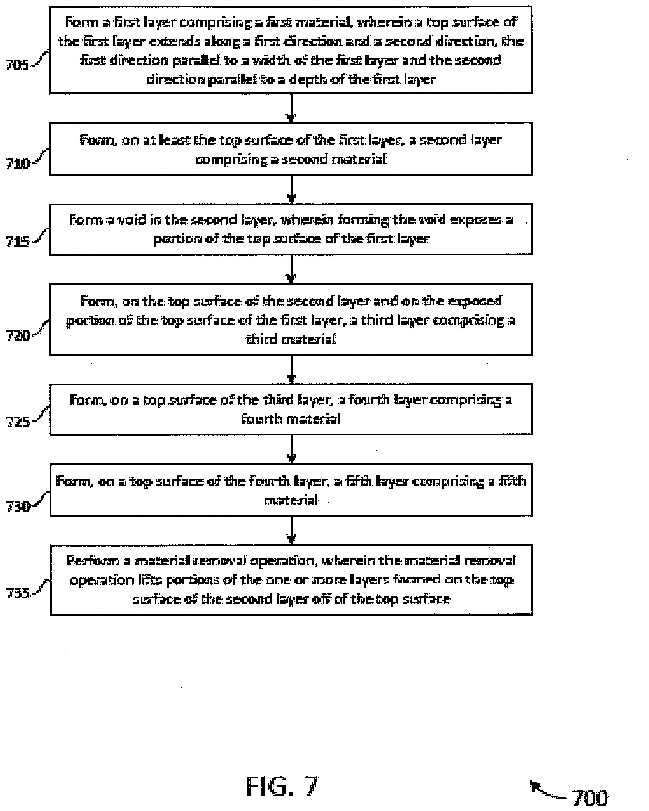

**FIG. 7** illustrates an example of a flowchart illustrating a method 700 that supports improved under-bump metallization structures and associated methods of formation. The operations of the method 700 may be implemented by a manufacturing system or one or more machines configured for performing the one or more operations as described herein. In some cases, a manufacturing system or machine may execute instructions to control one or more functional elements to perform the described operations. Additionally, or alternatively, a machine or manufacturing system may perform aspects of the described operations using special-purpose hardware.

At 705, the method 700 may include forming a first layer comprising a first material. In some cases, a top surface of the first layer may extend along a first direction and a second direction. The first direction may be parallel to a width of the first layer and the second direction may be parallel to a depth of the first layer. The operations may be performed in accordance with examples as described herein. In some examples, aspects of the operations may be performed using a special-purpose machine or manufacturing system.

At 710, the method 700 may include forming, on at least the top surface of the first layer, a second layer. The second layer may include a second material. The operations may be performed in accordance with examples as described herein. In some examples, aspects of the operations may be performed using a special-purpose machine or manufacturing system.

At 715, the method 700 may include forming a void in the second layer. In some cases, forming the void may expose a portion of the top surface of the first layer. The operations may be performed in accordance with examples as described herein. In some examples, aspects of the operations may be performed using a special-purpose machine or manufacturing system.

At 720, the method 700 may include forming one or more layers on a top surface of the second layer. For example, the method 700 may include forming, on the top surface of the second layer and on the exposed portion of the top surface of the first layer, a third layer comprising a third material. The operations may be performed in accordance with examples as described herein. In some examples, aspects of the operations may be performed using a special-purpose machine or manufacturing system.

At 725, the method 700 may include forming, on a top surface of the third layer, a fourth layer comprising a fourth material. The operations may be performed in accordance with examples as described herein. In some examples, aspects of the operations may be performed using a special-purpose machine or manufacturing system.

At 730, the method 700 may include forming, on a top surface of the fourth layer, a fifth layer comprising a fifth material. The operations may be performed in accordance with examples as described herein. In some examples, aspects of the operations may be performed using a special-purpose machine or manufacturing system.

At 735, the method 700 may include performing a material removal operation (e.g., a lift-off operation using an adhesive film). The material removal operation may remove one or more portions of the one or more layers formed on the top surface of the second layer. The operations may be performed in accordance with examples as described herein. In some examples, aspects of the operations may be performed using a special-purpose machine or manufacturing system.

While this detailed description has set forth some embodiments of the present invention, the appended claims also cover other embodiments of the present invention which may differ from the described embodiments according to various modifications and improvements.

## Claims

1. A method comprising:
forming a first layer comprising a first material, wherein a top surface of the first layer extends along a first direction and a second direction, the first direction parallel to a width of the first layer and the second direction parallel to a depth of the first layer;
forming, on at least the top surface of the first layer, a second layer comprising a second material;
forming a void in the second layer, wherein forming the void exposes a portion of the top surface of the first layer;
forming one or more layers on a top surface of the second layer and on the exposed portion of the top surface of the first layer; and
performing a material removal operation, wherein the material removal operation lifts portions of the one or more layers formed on the top surface of the second layer off of the top surface.

2. The method of claim 1, wherein forming the one or more layers comprises:
forming, on the top surface of the second layer and on the exposed portion of the top surface of the first layer, a third layer comprising a third material;
forming, on a top surface of the third layer, a fourth layer comprising a fourth material; and
forming, on a top surface of the fourth layer, a fifth layer comprising a fifth material.

3. The method of claim 1 or 2, wherein performing the material removal operation comprises:
removing the portions of the one or more layers using an adhesive film.

4. The method of any of claims 1 to 3, further comprising:
forming a sixth material on a top layer of the one or more layers, wherein forming the sixth material avoids forming the sixth material in contact with the second layer..

5. The method of claim 4, wherein the sixth material comprises a solder material.

6. The method of any of claims 1 to 5, further comprising:
performing a reflow operation, wherein performing the reflow operation couples the first layer with a device via at least the one or more layers.

7. The method of any of claims 1 to 6, further comprising:
forming, on a top layer of the one or more layers, a pillar comprising a seventh material, wherein a height axis of the pillar extends along a third direction parallel to a height of the first layer; and
forming, on a top surface of the pillar, a seventh layer comprising a fourth material.

8. An apparatus comprising:
a first layer comprising a first material, wherein the first layer has a width parallel to a first direction, a depth parallel to a second direction, and a height parallel to a third direction;
a second layer comprising a second material formed on at least a top surface of the first layer, the top surface of the first layer extending along the first direction and the second direction;
a void formed in the second layer, wherein extents of the void comprise sidewalls of the second layer and a portion of the top surface of the first layer, wherein the sidewalls of the second layer are parallel to the third direction; and
one or more layers formed on the sidewalls of the second layer and on the portion of the top surface of the first layer, the one or more layers for coupling the first layer with a bonding material.

9. The apparatus of claim 8, wherein the one or more layers comprise:
a third layer comprising a third material, the third layer formed on a top surface of the second layer;
a fourth layer comprising a fourth material, the fourth layer formed on a top surface of the third layer; and
a fifth layer comprising a fifth material, the fifth layer formed on a top surface of the fourth layer.

10. The method of any of claims 1 to 7, or the apparatus of claim 8 or 9, wherein the first material comprises aluminum, the second material comprises silicon nitride, the third material comprises titanium, the fourth material comprises nickel, and the fifth material comprises silver.

11. The method of any of claims 1 to 7, or the apparatus of any of claims 8 to 10, wherein a height dimension of the fourth layer is greater than or equal to 300 nanometers.

12. The apparatus of any of claims 8 to 11, wherein the bonding material comprises solder.

13. The method of any of claims 1 to 7, further comprising forming, or the apparatus of any of claims 8 to 12, further comprising:
a sixth layer comprising the second material, wherein the first layer is formed on the sixth layer.

14. The apparatus of any of claims 8 to 13, further comprising:
a pillar comprising a seventh material, wherein a height axis of the pillar extends along the third direction; and
a seventh layer comprising a fourth material, the seventh layer formed on a top surface of the pillar.

15. The method of any of claims 1 to 7, or the apparatus of any of claims 8 to 14, wherein the one or more layers comprise an under-bump metallization.
